Europäisches Patentamt

European Patent Office

Office européen des brevets

(19)

(11) Veröffentlichungsnummer: **0 135 733**
A2

(12) **EUROPÄISCHE PATENTANMELDUNG**

(21) Anmeldenummer: **84109176.2**

(51) Int. Cl.⁴: **H 01 L 29/91,** H 01 L 29/36

(22) Anmeldetag: **02.08.84**

(30) Priorität: **06.08.83 DE 3328521**

(43) Veröffentlichungstag der Anmeldung: **03.04.85**
**Patentblatt 85/14**

(84) Benannte Vertragsstaaten: **AT CH FR GB IT LI SE**

(71) Anmelder: **SEMIKRON, GESELLSCHAFT FÜR GLEICHRICHTERBAU UND ELEKTRONIK M.B.H., Sigmundstrasse 200, D-8500 Nürnberg 82 (DE)**

(72) Erfinder: **Chadda, Madan Mohan, An der Breiting 7, D-8500 Nürnberg (DE)**

(54) **Epitaxialdiode für hohe Sperrspannung.**

(57) Es wird eine Epitaxialdiode mit einem Substrat und einer hochohmigen Mittelzone des einen Leitungstyps und mit einer Außenzone des anderen Leitungstyps sowie mit Rekombinationszentren zur Reduzierung der Trägerlebensdauer beschrieben, bei der hohe Sperrspannungsbelastbarkeit dadurch erzielt wird, daß zwischen Substrat und Mittelzone eine erste Zwischenzone mit übereinstimmendem Leitungstyp und mit niedrigerer Dotierungskonzentration als diejenige des Substrats sowie zwischen Mittelzone und Außenzone eine zweite Zwischenzone des anderen Leitungstyps mit niedrigerer Dotierungskonzentration als diejenige der Außenzone angeordnet ist und als Rekombinationszentren Schwermetallionen vorgesehen sind.

## EPITAXIALDIODE FÜR HOHE SPERRSPANNUNG

Die Erfindung betrifft eine Epitaxialdiode für hohe Sperrspannung mit einem die erste Außenzone bildenden Substrat sehr hoher Störstellenkonzentration des einen Leitungstyps, einer mittleren, epitaktischen, hochohmigen Zone gleichen Leitungstyps und einer die zweite Außenzone bildenden, hochdotierten Zone des anderen Leitungstyps sowie mit zusätzlichen, die Trägerlebensdauer reduzierenden Rekombinationszentren.

In der Stromrichtertechnik werden z.B. zur verlustarmen Umwandlung einer Gleichspannung und zur beliebigen Veränderung der erzeugten Spannung Thyristor-Schaltungen oder Transistorschaltungen mit sogenannter Freilaufdiode verwendet. Dabei werden an solche Dioden hinsichtlich ihrer Strom- und Spannungsbelastbarkeit den Kenngrößen der Thyristoren bzw. Transistoren entsprechende Forderungen gestellt. Insbesondere sind für eine Verwendung in Schaltungen mit selbstgeführten Thyristoren Dioden mit kurzer Freiwerdezeit notwendig.

Für einen solchen Einsatz sind Gleichrichterdioden mit psn-Struktur bekannt, bei welchen die mittlere Zone durch Epitaxie hergestellt ist. Bei einer Ausführungsform sind die Rekombinationszentren durch Diffusion von Gold nach der Herstellung der epitaktischen Mittelzone und bei einer anderen nach der Herstellung der psn-Schichtenfolge erzeugt.

Beiden Arten von Gleichrichterdioden ist gemeinsam, daß ihr Schichtenaufbau bezüglich Bemessung und verfahrensbedingter Eigenschaften nur eine Sperrspannungsbelastbarkeit bis etwa 600 Volt zuläßt und außerdem vielfach nicht die einsatzbedingt geforderte Freiwerdezeit aufweist.

Aber auch eine Änderung der Bemessung des Schichtenaufbaus solcher Gleichrichterdioden würde nicht zu der gewünschten Verbesserung der physikalischen Eigenschaften solcher Halbleiterbauelemente führen.

Der Erfindung liegt die Aufgabe zugrunde, Gleichrichterdioden für hohe Sperrspannungsbelastbarkeit zu schaffen, die für Schaltungen mit Thyristoren hoher Leistung und kleiner Freiwerdezeit bzw. für Schaltungen mit Transistoren hoher Leistung und kleiner Schaltzeit einsetzbar sind.

Die Lösung der Aufgabe besteht bei Dioden der eingangs genannten Art darin, daß zwischen Substrat und mittlerer Zone eine epitaktische, gegenüber der mittleren Zone höher dotierte, erste Zwischenzone des einen Leitungstyps und zwischen der mittleren Zone und der zweiten Außenzone eine epitaktische, gegenüber der zweiten Außenzone niedriger dotierte, zweite Zwischenzone des anderen Leitungstyps angeordnet sind, und daß als Rekombinationszentren Schwermetallionen vorgesehen sind.

Vorteilhafte Ausgestaltungen der Erfindung sind in den Unteransprüchen gekennzeichnet.

Die Vorteile der Erfindung liegen darin, daß durch Wahl der Verfahrenstechnik eine gleichmäßige Verteilung von Gold im Schichtenaufbau und dadurch bestmögliche Trägerlebensdauerverhältnisse vorliegen, daß unerwünschte Defekte im Zusammenhang mit bekannten Diffusionsverfahren vermieden sind, daß auch im Hinblick auf die Goldkonzentration die in den verschiedenen Zonen gebildeten Störstellenprofile im Verfahrensablauf erhalten bleiben, und daß die Sperrspannungsbelastbarkeit im wesentlichen ohne unzulässige Erhöhung des Durchlaßspannungsabfalls in gewünschter Weise erhöht werden kann.

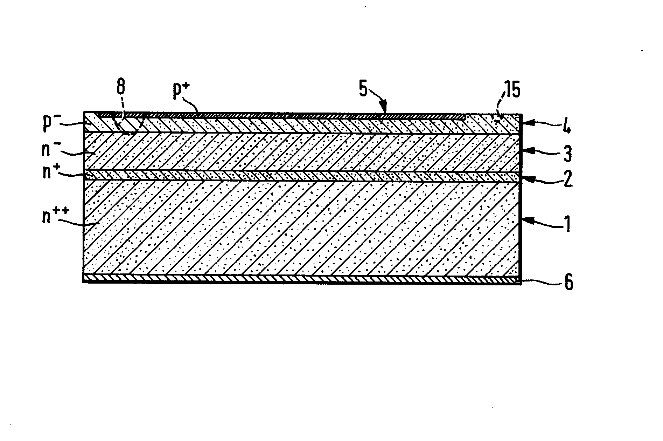

Anhand der in der Zeichnung im Querschnitt gezeigten Schichtenfolge wird der Gegenstand der Erfindung erläutert. Zur Veranschaulichung der Schichtdickenrelation ist die Struktur stark vergrößert dargestellt.

Als Substrat 1 dient ein scheibenförmiges, extrem z.B. mit Antimon dotiertes, n-leitendes Ausgangsmaterial, das zur Gewährleistung der notwendigen mechanischen Stabilität bei der Herstellung der Struktur eine Dicke von ca. 250 $\mu$m aufweist, aber auch dicker ausgebildet sein kann. Es könnte dafür auch eine vergleichsweise dünne und metallisierte Substratscheibe verwendet werden. Mit Rücksicht jedoch auf die zur Diffusion von Schwermetallionen notwendige Wärmebehandlung und die dabei mögliche unerwünschte Beeinflussung des Halbleitermaterials durch eine zuvor aufgebrachte Kontaktelektrode im Falle einer solchen metallisierten dünnen Substratscheibe ist demgegenüber ein dickeres, nicht metallisiertes Ausgangsmaterial von Vorteil. Ein Teil der Scheibendicke wird nach Fertigstellung der Diode abgetragen, darnach werden die freien Hauptflächen kontaktiert.

An das Substrat 1 grenzt eine als erste Zwischenzone 2 bezeichnete, niedriger dotierte Schicht gleichen Leitungstyps an mit einer Störstellenkonzentration im Bereich von $10^{17}$ bis $10^{18}/cm^3$ und mit einer Dicke im Bereich von ca. 2 bis 15 $\mu$m.

Diese erste Zwischenzone 2 ist mit Phosphor dotiert.
Wegen der hohen Getterwirkung von Phosphor wird dadurch erreicht, daß aus den angrenzenden Epitaxieschichten unerwünschte Fremdstoffe jeder Art weitgehend entfernt werden. Außer unvermeidbaren Schwermetallionen enthalten solche Epitaxieschichten auch andere Verunreinigungen, welche die physikalischen Eigenschaften des Halbleitermaterials ungünstig beeinflussen
können.

Die Dicke der Zone 2 ist einerseits durch die Forderung nach ausreichender Getterwirkung und andererseits, im Hinblick auf die höheren Kosten des Epitaxieverfahrens im Vergleich zu anderen Methoden der Herstellung dotierter Schichten, durch wirtschaftliche
Gesichtspunkte bestimmt.

Auf die erste Zwischenzone 2 folgt die hochohmige
Mittelzone 3 vom gleichen Leitungstyp mit niedrigster
Störstellenkonzentration, nämlich $10^{13}$ bis $10^{14}/cm^3$
und mit einer Dicke von etwa 40 bis 80 $\mu$m, die durch
die gewünschte Sperrspannungsbelastbarkeit bestimmt
ist.

Bei herkömmlichen Gleichrichterdioden mit hochohmiger
Mittelzone und angrenzenden, hochdotierten Außenzonen
ist eine Erhöhung der Sperrspannungsbelastbarkeit bekanntlich durch Erweiterung der Mittelzone erreichbar.
Damit nimmt aber über den Durchlaßspannungsabfall der
Anordnung die Verlustleistung zu. Wird bei Dioden mit
kleinerer Freiwerdezeit die Mittelzone erweitert, so
nimmt der Durchlaßspannungsabfall sowohl mit der Zonenweite als auch mit der Reduzierung der Freiwerdezeit
zu.

Die Erfindung geht nun von der Erkenntnis aus, daß,
aufgrund physikalischer Zusammenhänge, durch Diffusion von Schwermetallionen der Durchlaßspannungsabfall in einer hochohmigen n-leitenden Zone zunimmt, dagegen in einer hochohmigen p-leitenden Zone im wesentlichen nicht zunimmt. Unter Anwendung dieser Erkenntnis ist die n-leitende Mittelzone 3 dünner als bei üblichen Anordnungen ausgebildet, und zusätzlich ist die hochohmige, p-leitende, zweite Zwischenzone 4 vorgesehen. Beide Zonen weisen zusammen etwa die Dicke der mittleren Zone bekannter Anordnungen auf. Bei einer solchen Zonenfolge wird der Durchlaßspannungsabfall im wesentlichen nur durch Maßnah-men an der Mittelzone 3 und, gemäß der Erfindung, bei Reduzierung von deren Weite nach geringeren Verlusten hin verändert.

Die Einbringung der zweiten Zwischenzone 4 führt demzufolge in überraschend einfacher Weise gezielt zu einer Erhöhung der Sperrspannungsbelastbarkeit bei gleichzeitig niedrigen Durchlaßverlusten.

Die zweite Zwischenzone 4 ist z.B. durch Dotierung mit Aluminium oder Bor mit einer Störstellenkonzentration im Bereich von $10^{13}$ bis $10^{14}$/cm$^3$ hergestellt.

Auf die Zone 4 ist die hochdotierte, p-leitende zweite Außenzone 5 aufgebracht mit einer Konzentration von $10^{19}$ bis $10^{20}$/cm$^3$ und einer Dicke von ca. 0,5 bis 5 μm. Die Außenzone 5 dient als Kontaktierungszone, wobei die Kontaktmetallschicht bei einer Zonendicke von z.B. 2 μm ca. 0,5 μm betragen kann.

Durch Golddiffusion sind insbesondere in den Epitaxieschichten 2 bis 4 der oben beschriebenen Schichtenfolge Rekombinationszentren gebildet.

Das Substrat 1 ist mit einer Kontaktelektrode 6, z.B. aus Aluminium und Silber oder aber aus Nickel und Gold, versehen.

Um einen langzeitstabilen Schichtenaufbau herzustellen, ist in der Hauptfläche auf der Zone 5 z.B. eine Grabenstruktur vorgesehen, wie dies im linken Abschnitt der Figur mit 8 bezeichnet ist. Demgegenüber kann aber auch die Zone 5 in Planartechnik mit Potentialring 15 ausgebildet sein, wie dies im rechten Abschnitt der Figur angedeutet ist.

Zur Herstellung der Anordnung nach der Erfindung wird ein vorgefertigtes Substrat 1 gewählter Dicke verwendet, welches nach bekanntem Verfahren gleichmäßig dotiert ist. Auf diesem Substrat werden durch Epitaxie die erste Zwischenzone 2, die mittlere Zone 3 und die zweite Zwischenzone 4 aufgebracht. Abschließend kann die äußere Zone 5 durch Planartechnik, wegen ihrer geringen Dicke nur bei etwa 900° bis 950° Celsius, oder durch Ionen-Implantation hergestellt werden. Im ersten Fall wird der Potentialring zur Erhöhung der Spannungsbelastbarkeit gleichzeitig erzeugt, im zweiten Fall wird anschließend die Grabenstruktur gebildet.

Nach Fertigstellung dieses Aufbaus wird Gold bei ca. 900° Celsius eindiffundiert. Abschließend werden die Kontaktelektroden auf beiden Hauptflächen hergestellt.

## PATENTANSPRÜCHE

1. Epitaxialdiode für hohe Sperrspannung mit einem die erste Außenzone bildenden Substrat sehr hoher Störstellenkonzentration des einen Leitungstyps, einer mittleren, epitaktischen, hochohmigen Zone gleichen Leitungstyps und einer die zweite Außenzone bildenden, hochdotierten Zone des anderen Leitungstyps sowie mit zusätzlichen, die Trägerlebensdauer reduzierenden Rekombinationszentren, d a d u r c h   g e k e n n - z e i c h n e t ,
daß zwischen Substrat (1) und mittlerer Zone (3) eine epitaktische, gegenüber der mittleren Zone höher dotierte, erste Zwischenzone (2) des einen Leitungstyps und zwischen der mittleren Zone (3) und der zweiten Außenzone (5) eine epitaktische, gegenüber der zweiten Außenzone niedriger dotierte, zweite Zwischenzone (4) des anderen Leitungstyps angeordnet sind, und daß als Rekombinationszentren Schwermetallionen vorgesehen sind.

2. Epitaxialdiode nach Anspruch 1, dadurch gekennzeichnet, daß die zweite Außenzone (5) mittels Ionen-Implantation hergestellt ist.

3. Epitaxialdiode nach Anspruch 1, dadurch gekennzeichnet, daß die zweite Außenzone (5) durch Epitaxie hergestellt ist.

4. Epitaxialdiode nach einem der Ansprüche 1 bis 3, dadurch gekennzeichnet, daß die Dicke der ersten Zwischenzone (2) ca. 1/30 bis 1/5 der Dicke der mittleren Zone (3) beträgt.

5. Epitaxialdiode nach einem der Ansprüche 1 bis 3,

8

dadurch gekennzeichnet, daß die Dicke der zweiten Zwischenzone (4) ca. 1/7 bis 1/4 der Dicke der mittleren Zone (3) beträgt.

6. Epitaxialdiode nach einem der Ansprüche 1 bis 3, dadurch gekennzeichnet, daß die Dicke der zweiten Außenzone (5) ca. 0,5 $\mu$m bis 5,0 $\mu$m beträgt.

7. Epitaxialdiode nach einem der vorhergehenden Ansprüche, dadurch gekennzeichnet, daß die Störstellenkonzentration der ersten Zwischenzone (2) $10^{17}$ bis $10^{18}$/cm$^3$ beträgt.

8. Epitaxialdiode nach einem der vorhergehenden Ansprüche, dadurch gekennzeichnet, daß die Störstellenkonzentration der zweiten Zwischenzone (4) $10^{14}$ bis $10^{15}$/cm$^3$ beträgt.

9. Epitaxialdiode nach einem der vorhergehenden Ansprüche, dadurch gekennzeichnet, daß die Störstellenkonzentration der zweiten Außenzone (5) $10^{18}$ bis $10^{20}$/cm$^3$ beträgt.

10. Epitaxialdiode nach einem der vorhergehenden Ansprüche, dadurch gekennzeichnet, daß als Schwermetall für Rekombinationszentren Gold eindiffundiert ist.

11. Verfahren zum Herstellen von Dioden nach einem der Ansprüche 1 bis 10, dadurch gekennzeichnet, daß auf dem Substrat (1) in der Reihenfolge ihrer Anordnung die erste Zwischenzone (2), die mittlere Zone (3) und die zweite Zwischenzone (4) aufgebracht werden, daß darnach die Diffusion von Schwermetallionen zur Erzeugung von Rekombinationszentren erfolgt, und daß abschließend die zweite Außenzone (5) hergestellt wird.